# NOUVEAU FASCICULE DE BREVET EUROPEEN

(11) **EP 2 242 647 B2**
(45) Date de publication et mention de la décision concernant l'opposition: **15.07.2015**
(45) Mention de la délivrance du brevet: 30.11.2011
(21) Numéro de dépôt: 09711062.1
(22) Date de dépôt: 13.02.2009
(51) Int. Cl.: B32B 27/00, C08L 23/08, C08L 31/04, C08L 35/00, C08L 51/06

(54) **STRUCTURE MULTICOUCHE COMPRENANT UN LIANT À BASE DE COPOLYMÈRE ÉTHYLÈNE-ESTER VINYLIQUE D'ACIDE CARBOXYLIQUE ET DE POLYOLÉFINE CONTENANT UN MONOMÈRE FONCTIONNEL**
MEHRSCHICHTIGE STRUKTUR ENTHALTEND EIN BINDEMITTEL AUF DER BASIS EINES ETHYLEN-CARBONSÄURE-VINYLESTER-COPOLYMERS UND POLYOLEFINS MIT EINEM FUNKTIONELLEN MONOMER
MULTILAYER STRUCTURE COMPRISING A BINDER BASED ON ETHYLENE /CARBOXYLIC ACID VINYL ESTER COPOLYMER AND POLYOLEFIN CONTAINING A FUNCTIONAL MONOMER

(30) Priorité: 13.02.2008 FR 0850908; 04.03.2008 US 33452 P
(43) Date de publication de la demande: 27.10.2010
(73) Titulaire: ARKEMA FRANCE, 92700 Colombes (FR)
(72) Inventeur: CARTIER, Laurent B., Wayne, PA 19087 (US); COLLAS, Olivier, F-27800 Saint Pierre De Salerne (FR); CORFIAS-ZUCCALLI, Catherine, F-27500 Pont-Audemer (FR); DEVISME, Samuel, F-76000 Rouen (FR)
(74) Mandataire: Gavin, Pablo
(86) Numéro de dépôt international: PCT/FR2009/050229
(87) Numéro de publication internationale: WO 2009/101369

(56) Documents cités:
- EP-A- 1 460 109
- US-B1- 6 455 161

## Description

La présente invention concerne une structure multicouche comprenant au moins un support constitué de PMMA et une couche formée de liant à base d'un mélange de copolymère éthylène/ester vinylique d'acide carboxylique et de polyoléfine ayant des propriétés adhésives.

Le liant de cette structure peut avantageusement être utilisé comme encapsulant dans les modules photovoltaïques.

### Etat de la technique

On connaît des liants constitués de copolymère éthylène/ester vinylique qui permettent l'adhérence à certains matériaux polymères (comme par exemple le polyéthylène, le polystyrène, ou encore les métaux). Ces liants ont l'avantage d'être peu coûteux, transparents et faciles à mettre en oeuvre. Parmi les copolymères de ce type, on peut citer les copolymères Ethylène/Acétate de Vinyle (EVA). On les retrouve dans de nombreux domaines, comme par exemple ceux des panneaux solaires (appelé encore « module photovoltaïque ») ou du verre feuilleté.

Cependant, l'adhérence à certains supports (verre, poly-méthacrylate de méthyle (PMMA)) n'est pas suffisante pour certaines applications.

En particulier, dans le domaine des modules photovoltaïques, l'EVA est utilisé comme liant afin « d'encapsuler » les cellules photovoltaïques. Ces cellules photovoltaïques sont généralement reliées entre elles par des fils métalliques. Le liant à base EVA a des propriétés d'adhérence au métal et aux cristaux de silicium, ce qui permet d'éviter le contact de la cellule avec le dioxygène de l'air et d'en limiter la corrosion. Il a alors la fonction d'« encapsulant »). Ces cellules photovoltaïques encapsulées sont situées sur un support de protection inférieur du module (appelé «back sheet »), dont la fonction principale est de protéger les cellules photovoltaïques de l'humidité. Ce backsheet peut être formé d'une structure du type multicouche polymère fluoré / polyéthylène téréphtalate / polymère fluoré ou du type polymère fluoré / polyéthylène téréphtalate / EVA. Une plaque de verre ou de polymère transparent est appliquée de l'autre côté du liant afin de permettre la protection de la cellule aux chocs et à l'humidité extérieure, cette couche de protection supérieure étant couramment appelée « front sheet ». Si l'encapsulant n'adhère pas suffisamment aux différents supports de la structure (cellules, back sheet, front sheet), la présence d'humidité ou d'air au contact des cellules et du liant se fait à l'intérieur du panneau solaire, ce qui provoque son vieillissement accéléré par l'endommagement des cellules et par le décollement à l'interface back sheet/encapsulant ou l'interface encapsulant/front sheet.

De même, dans le cas du verre feuilleté, l'EVA peut servir de liant entre les feuillets de verre. Un décollement des feuillets peut être observé au cours du temps lorsque l'EVA est utilisé pur.

De plus, ces liants constitués d'EVA présentent peu d'adhérence avec le PMMA. Or, pour les panneaux solaires, il est possible de remplacer la couche de protection en verre par une plaque de PMMA.

Il est aussi possible dans le cas des verres feuilletés qu'au moins une des couches soit en PMMA, pour permettre par exemple l'élaboration de structures colorées par ajout de pigments organiques dans la masse de la couche de PMMA.

Pour remédier à ces problèmes de collage, des agents de couplage sont souvent mélangés au liant à base d'EVA. Ces agents, qui vont permettre d'améliorer l'adhérence entre le liant et le support, sont des produits choisis parmi les silanes ou les titanes organiques. Lors de la mise en oeuvre des panneaux solaires, les composants sont assemblés par laminage, et le panneau est tiré sous vide par l'intermédiaire d'une membrane en silicone. Or, cette membrane en silicone a tendance à se dégrader au contact de ces agents de couplage ; Il est donc nécessaire d'en limiter l'usage. Ceci est un problème majeur pour les fabricants de modules photovoltaïques à l'heure actuelle car ces membranes en silicones sont coûteuses et qu'une mise à l'arrêt de la production est nécessaire le temps de leur remplacement. De plus, les agents de couplage ont tendance à s'hydrolyser au contact de l'humidité et à perdre leur activité au fil du temps.

De plus, dans le cas du PMMA, l'effet de ces agents de couplage est très faible, ce qui ne permet pas d'assurer une adhérence suffisante pour son utilisation dans les domaines des panneaux solaires et du verre feuilleté.

Des solutions alternatives à ces liants d'EVA ont déjà été décrites dans l'art antérieur.

La demande WO2006/09393 décrit un encapsulant dont la tenue au vieillissement est améliorée par l'ajout d'absorbants afin d'augmenter le tenue de vie des panneaux solaires. Elle ne concerne pas l'amélioration de l'adhérence entre les différents composés du panneau.

La demande US2006/0165929 décrit une structure multicouche comprenant au moins 3 couches, la couche intérieure étant une couche de polymère prise en « sandwich » entre deux couches de ionomère. Cette structure sert de liant avec un support en verre. Cependant, ce liant nécessite l'élaboration d'un tricouche, ce qui rend le procédé de fabrication plus complexe et augmente les coûts de production.

Le brevet US 6,414,236 décrit un liant constitué d'un terpolymère éthylène/ester d'acide gras insaturé/acide gras insaturé. Ce liant permet d'obtenir une meilleure tenue au vieillissement à la chaleur et à l'humidité.

Dans la demande de brevet US 2005/0069710 de la demanderesse, il est décrit un film multicouche utile pour revêtir des substrats, ce film étant composé d'une couche d'un mélange de fluoropolymère et de polymère fonctionnalisé qui peut être du PMMA fonctionnalisé, adhérant à une couche de liant formé d'un copolymère éthylène/(méth)acrylate/époxyde. Ce liant n'adhère à la couche du mélange que si le PMMA est fonctionnalisé. De plus, le pressage doit être fait à température et sous pression élevées (240°C, 40 MPa) pour provoquer l'adhérence, ce qui peut entraîner une dégradation thermique des différents composants du support, ainsi que leur déformation. Par exemple, cette température empêche l'utilisation d'agents de couplage qui peuvent entraîner un dégazage à cette température.

Pour que le liant puisse être utilisé dans les modules photovoltaïques et en particulier comme encapsulant des cellules solaires, il est avantageux que ce liant présente de bonnes propriétés de transparence. En effet, lorsque le rayonnement solaire est peu diminué lors de son passage dans les couches recouvrant les cellules solaires, le rendement des cellules solaires encapsulées est supérieur.

Préférentiellement, un liant transparent présente un niveau de trouble inférieur ou égal à 20%, voire à 10%, ce niveau de trouble (ou Haze) étant évalué selon la norme ASTM D1003, sur un film de 500 µm d'épaisseur dudit liant et pour au moins une longueur d'onde du domaine visible (de 380 à 780 nm).

Il est également préférable que la résistivité électrique du liant soit suffisamment élevée. Lorsque la résistivité est élevée, on peut diminuer l'épaisseur du film encapsulant sans risquer un court-circuit du module photovoltaïque. Avantageusement, le liant présente une résistivité électrique transversale supérieure ou égale à 10¹³ ohm.cm, voire à 10¹⁴ lorsque l'on mesure à 23°C cette résistivité sur un film de 100µm et à une fréquence de 0,01 Hz.

### Résumé de l'invention

Le but de la présente invention est de fournir une structure multicouche comprenant une couche formée de liant qui montre, par rapport aux liants classiques à base d'EVA, une adhérence améliorée sur un support constitué de PMMA, fonctionnalisé ou non. De manière préférée, la fabrication du liant de l'invention est plus économique que les solutions susmentionnées.

Selon l'invention, une structure multicouche est définie selon la revendication 1. Le ratio massique de (B)/((A)+(B)) est compris dans la gamme allant de 0,05 à inférieur à 1 et préférentiellement entre 0,05 et 0,5.

Le mélange de ces deux polymères permet la formation d'un liant qui, tout en pouvant former un film monocouche, a des propriétés d'adhérence à un support constitué de PMMA.

Plus particulièrement, l'invention porte sur l'utilisation de cette structure multicouche dans les modules photovoltaïques. Un autre avantage de ce liant est qu'il présente une bonne adhésion, même sans utiliser d'agents de couplage comme les silanes.

Par ailleurs, le liant adhère à un support constitué de PMMA du module photovoltaïque, même lorsque ce liant est pressé à basse température et/ou sous pression réduite. Par basse température, on entend une température avantageusement inférieure à 160°C, voire à 150°C. Par pression réduite, on entend une pression de préférence inférieure à 10 MPa.

De plus, ce liant présente une transparence et une résistivité électrique lui permettant d'être avantageusement utilisé comme encapsulant dans les modules photovoltaïques.

Avantageusement, le ratio massique de (B)/((A)+(B)) est compris entre 0,05 et 0,4, et préférentiellement compris entre 0,15 et 0,4.

Ce liant présente en outre un compromis prix/performance qui le rend économiquement rentable.

Il est précisé que, dans la présente description de l'invention, lorsque le polymère, c'est à dire le copolymère (A) ou la polyoléfine (B), comprend un monomère, cela signifie que ce monomère est sous forme polymérisée dans le polymère.

On peut par exemple mesurer les quantités de chaque monomère à l'intérieur de la polyoléfine (B) et le copolymère (A) en utilisant les techniques connues de spectroscopie infrarouge à transformée de Fourrier et la norme ISO8985. S'agissant de la polyoléfine (B), c'est un polymère comprenant comme monomère une alpha-oléfine. Préférentiellement, l'alpha-oléfine est de l'éthylène.

Selon un premier mode de réalisation, le monomère fonctionnel (X) est greffé sur la polyoléfine (B).

Selon un deuxième mode de réalisation, le monomère fonctionnel (X) est copolymérisé dans la chaîne de la polyoléfine (B).

La quantité du monomère fonctionnel (X) contenu dans la polyoléfine (B) est comprise de manière préférée entre 0,05 et 10 % en masse, que ce monomère soit greffé ou copolymérisé.

Le monomère fonctionnel (X) contenu dans la polyoléfine (B) est l'anhydride maléique.

Un des liants préférés comprend un copolymère éthylène-(meth)acrylate d'alkyle-anhydride maléique comme polyoléfine fonctionnelle (B).

Un autre liant tout particulièrement préféré comprend un copolymère éthylène-acétate de vinyle-anhydride maléique comme polyoléfine fonctionnelle (B).

De manière avantageuse, le copolymère (A) est un copolymère éthylène-acétate de vinyle.

Le taux d'ester vinylique d'acide carboxylique dans le copolymère (A) est avantageusement compris entre 15 et 60 % en masse d'ester de vinyle et plus préférentiellement entre 25 et 45 %.

La composition du liant de cette structure multicouche peut prendre la forme d'un film. Dans les gammes d'ester vinylique du copolymère (A) ci-dessus, le film a des propriétés d'adhérence encore meilleures et sa mise en forme par les procédés de mise en oeuvre connus est facilitée.

De même, il est avantageux que le liant ait un Melt Flow Index (MFI) compris entre 1 à 400 g/10min (ASTM D 1238 - 190°C - 2,16 kg), préférentiellement de 40 à 300 g/10min. L'Homme du métier pourra aisément fabriquer ce liant en sélectionnant les polymères (A) et (B) ayant une masse molaire et un taux de comonomère adéquats ou en modifiant le ratio massique (B)/((A)+(B)). Le liant a dans cette gamme de fluidité une adhésivité supérieure tout en pouvant être extrudé sous forme de film par des techniques classiques d'extrusion soufflage, d'extrusion laminage, d'extrusion couchage, de calandrage ou d'extrusion « cast ». Préférentiellement, on utilise l'extrusion soufflage, l'extrusion cast ou le calandrage pour former le film selon l'invention. L'Homme du métier pourra aisément déterminer les conditions opératoires de ces techniques d'extrusion (température dans l'extrudeuse, vitesse de rotation des vis, vitesse des rouleaux) pour pouvoir former un film à partir du liant de l'invention.

Lorsque la composition prend la forme d'un film, son épaisseur est préférentiellement comprise entre 50µm et 2000µm.

Le liant peut contenir en outre des additifs comme par exemple un agent réticulant, un agent de couplage ou un stabilisant ultraviolet (UV) ou encore des colorants.

La présente invention porte sur une structure multicouche comprenant un liant tel que défini précédemment et au moins un support constitué de PMMA.

De manière surprenante, bien que les surfaces du verre et du PMMA aient des propriétés de surface très différentes, le liant colle sur les deux supports. Cette polyvalence est un avantage, sans qu'il soit nécessaire de procéder à un traitement de surface préalable des supports.

Un procédé de fabrication d'une structure multicouche obtenue à partir d'un film de liant est également décrit.

L'utilisation du liant pour la fabrication de panneaux solaires, en particulier comme encapsulant des cellules photovoltaïques, et un module photovoltaïque comprenant ce liant sont décrits ainsi que l'utilisation des structures de l'invention pour la fabrication de panneaux solaires.

### Description détaillée de l'invention

Le liant comprend un mélange d'un copolymère éthylène/ester vinylique (A) et d'une polyoléfine (B) comportant un monomère fonctionnel (X) qui est l'anhydride maléique, le ratio massique de (B)/((A)+(B)) étant compris entre 0,05 et inférieur à 1, et préférentiellement entre 0,05 et 0,5. S'agissant de la polyoléfine (B), c'est un polymère comprenant comme monomère une alpha-oléfine.

On préfère les alpha-oléfines ayant de 2 à 30 atomes de carbone.

A titre d'alpha-oléfine, on peut citer l'éthylène, le propylène, 1-butène, 1-pentène, 3-méthyl-1-butène, 1-hexène, 4-méthyl-1-pentène, 3-méthyl-1-pentène, 1-octène, 1-décène, 1-dodécène, 1-tétradécène, 1-hexadécène, 1-octadécène, 1-eicocène, 1-dococène, 1-tétracocène, 1-hexacocène, 1-octacocène, et 1-triacontène. On préfère l'éthylène comme alpha-oléfine. Cette polyoléfine peut-être un homopolymère lorsqu'une seule alpha-oléfine est polymérisée dans la chaîne polymère. On peut citer comme exemples le polyéthylène (PE) ou le polypropylène (PP).

Cette polyoléfine peut aussi être un copolymère lorsque au moins deux comonomères sont copolymérisés dans la chaîne polymère, l'un des deux comonomères dit le « premier comonomère » étant une alpha-oléfine.

A titre de deuxième comonomère, on peut citer :
- une des alpha-oléfines déjà citées, celle-ci étant différente du premier comonomère alpha-oléfine,
- les diènes tels que par exemple le 1,4-hexadiéne ou l'éthylidène norbornène,
- les esters d'acides carboxyliques insaturés tels que par exemple les acrylates d'alkyle ou les méthacrylates d'alkyle regroupés sous le terme (méth)acrylates d'alkyles. Les chaînes alkyles de ces (méth)acrylates peuvent avoir jusqu'à 30 atomes de carbone, avantageusement de 1 à 12 atomes de carbone, préférentiellement de 1 à 6 atomes de carbone. On peut citer comme chaînes alkyles le méthyle, l'éthyle, le propyl, n-butyl, sec-butyl, Isobutyl, tert-butyl, pentyl, hexyl, heptyl, octyl, 2-ethylhexyl, nonyl, decyl, undecyl, dodecyl, tridecyl, tetradecyl, pentadecyl, hexadecyl, heptadecyl, octadecyl, nonadecyl, eicosyl, hencosyl, docosyl, tricosyl, tetracosyl, pentacosyl, hexacosyl, heptacosyl, octacosyl, nonacosyl. On préfère les (meth)acrylates de méthyle, éthyle et butyle comme esters d'acide carboxylique insaturés.
- les esters vinyliques d'acide carboxyliques. A titre d'exemples d'esters vinyliques d'acide carboxylique, on peut citer l'acétate de vinyle, le versatate de vinyle, le propionate de vinyle, le butyrate de vinyle, ou le maléate de vinyle. On préfère l'acétate de vinyle comme ester vinylique d'acide carboxylique.

On ne sortirait pas du cadre de l'invention si différents « deuxièmes comonomères » étaient copolymérisés dans la polyoléfine (B).

Dans le cadre de la présente invention, la polyoléfine (B) contient au moins un monomère fonctionnel (X) qui est l'anhydride maléique.

Comme monomère fonctionnel (X), on peut citer :
- les époxydes insaturés. Parmi ceux-ci, ce sont par exemple les esters et éthers de glycidyle aliphatiques tels que l'allylglycidyléther, le vinylglycidyléther, le maléate et l'itaconate de glycidyle, l'acrylate et le méthacrylate de glycidyle. Ce sont aussi par exemple les esters et éthers de glycidyle alicycliques tels que le 2-cyclohexène-1-glycidyléther, le cyclohexène-4,5-diglycidylcarboxylate, le cyclohexène-4-glycidyl carboxylate, le 5-norbornène-2-méthyl-2-glycidyl carboxylate et l'endocis-bicyclo(2,2,1)-5-heptène-2,3-diglycidyl dicarboxylate.
- les acides carboxyliques insaturés et leurs sels, par exemple l'acide acrylique ou l'acide méthacrylique et les sels de ces mêmes acides.
- les anhydrides d'acide carboxylique. Ils peuvent être choisis par exemple parmi les anhydrides maléique, itaconique, citraconique, allylsuccinique, cyclohex-4-ène-1,2-dicarboxylique, 4-méthylènecyclohex-4-ène-1,2-dicarboxylique, bicyclo(2,2,1)hept-5-ène-2,3-dicarboxylique, et x-méthylbicyclo(2,2,1)hept-5-ène-2,2-dicarboxylique.

Le monomère fonctionnel (X) peut être copolymérisé dans la chaîne de la polyoléfine (B) par procédé autoclave ou tubulaire, ou/et être greffé sur la polyoléfine (B). La polymérisation par procédé autoclave ou tubulaire des différents monomères (alpha-oléfine, comonomère(s)) avec le monomère fonctionnel (X) est connue de l'homme du métier. De même, le greffage est une opération connue en soi.

La polyoléfine (B) contenant le monomère fonctionnel (X) serait conforme à l'invention si plusieurs monomères fonctionnels (X) différents étaient copolymérisés ou/et greffés.

On ne sortirait pas du cadre de l'invention si la polyoléfine (B) contenant un monomère fonctionnel (X) est constitué d'un mélange de polyoléfines (B) dont au moins une contient un monomère fonctionnel (X) copolymérisé et/ou greffé. Selon un premier mode de réalisation où la polyoléfine (B) est greffée par un monomère fonctionnel (X), on préfère particulièrement comme polyoléfine (B) contenant un monomère fonctionnel (X) les copolymères éthylène-(méth)acrylate d'alkyle greffés par le monomère (X). La chaîne alkyle peut avoir de façon préférentielle jusqu'à 9 atomes de carbone. Ces copolymères comprennent avantageusement jusqu'à 50 % en masse de (méth)acrylate et de préférence entre 25 et 45 %.

On préfère encore plus particulièrement comme polyoléfine (B) contenant un monomère fonctionnel (X) les copolymères éthylène-ester vinylique d'acide carboxylique greffés par le monomère (X). Ces copolymères comprennent avantageusement jusqu'à 50 % en masse d'ester vinylique et de préférence entre 25 et 45 %.

Selon un deuxième mode de réalisation où le monomère fonctionnel (X) est copolymérisé dans la polyoléfine (B), on préfère utiliser comme polyoléfine (B) contenant un monomère fonctionnel (X) les copolymères éthylène-(méth)acrylate d'alkyle-anhydride maléique obtenus par copolymérisation des trois comonomères. La chaîne alkyle peut avoir de façon préférentielle jusqu'à 9 atomes de carbone. Ces copolymères comprennent avantageusement jusqu'à 50 % et de préférence entre 25 et 45 % en masse de (méth)acrylate d'alkyle et avantageusement entre 0,05 et 10 % en masse d'anhydride maléique.

De manière encore plus préférée, on préfère utiliser comme polyoléfine (B) contenant un monomère fonctionnel (X) les copolymères éthylène-acétate de vinyle-anhydride maléique obtenus par copolymérisation des trois comonomères, ces copolymères comprenant avantageusement jusqu'à 50 % et de préférence entre 25 et 45 % en masse de (méth)acrylate, avantageusement entre 0,05 et 10 % en masse d'anhydride maléique et préférentiellement entre 0,05 et 2 %.

En ce qui concerne le copolymère éthylène-ester vinylique d'acide carboxylique (A), on peut citer les mêmes esters vinyliques d'acide carboxylique que ceux décrits ci-dessus comme deuxième comonomère lorsque (B) est un copolymère. On préfère le copolymère éthylène-acétate de vinyle.

Le liant peut également comprendre au moins un polymère additionnel différent de la polyoléfine (B) et du copolymère (A) et en particulier au moins une polyoléfine additionnelle. A titre non limitatif, on peut citer comme exemples de polyoléfines additionnelles le polyéthylène, le polypropylène ou les copolymères de l'éthylène tels que le copolymère éthylène-(méth)acrylate d'alkyle.

Le copolymère (A) et/ou la polyoléfine (B) sont préférentiellement des polymères statistiques. Elles sont avantageusement obtenues peuvent être obtenues par polymérisation haute pression des monomères avec les procédés connus de l'homme du métier. Cette polymérisation est réalisée par exemple dans un réacteur tubulaire ou autoclave. Des procédés de copolymérisation utilisables sont par exemple ceux décrits dans le brevet US4788265, les demandes de brevets US2006/0149004A1, US2007/0032614 A1, FR2660660, FR2498609, FR256941 1 et FR2569412. Les polyoléfines comprises dans le liant peuvent également être synthétisées par les méthodes de catalyse connues de l'homme du métier, comme la catalyse Ziegler-Natta ou la catalyse métallocène. Par catalyse métallocène, on entend un catalyseur monosite constitué généralement d'un atome de zirconium ou de titane et de deux molécules cycliques alkyles liées au métal. Plus spécifiquement, les catalyseurs métallocènes sont habituellement composés de deux cycles cyclopentadiéniques liés au métal. Ces catalyseurs sont fréquemment utilisés avec des aluminoxanes comme cocatalyseurs ou activateurs, de préférence le méthylaluminoxane (MAO). L'hafnium peut aussi être utilisé comme métal auquel le cyclopentadiène est fixé. D'autres métallocènes peuvent inclure des métaux de transition des groupes IV A, V A, et VI A. Des métaux de la série des lanthanides peuvent aussi être utilisés. Par polyoléfines obtenues par catalyse métallocène monosite, on entend des polyoléfines ayant un indice de polydispersité inférieur à 3, l'indice de polydispersité étant défini par le ratio masse moléculaire moyenne en poids M_{w} et masse moléculaire moyenne en nombre Mₙ (ratio M_{w}/Mₙ).

Le liant peut comprendre essentiellement des polyoléfines comme polymères, par exemple comprendre plus de 90% de polyoléfines par rapport à la masse totale des polymères du liant, voire plus de 95% ou être constitué de polyoléfines comme polymères du liant.

Le liant peut comprendre en outre des additifs, en particulier ceux classiquement utilisés dans les panneaux photovoltaïques. A titre d'exemple, on peut citer les agents réticulant, les agents de couplage, les stabilisants UV, les charges, les agents plastifiants, les agents retardateurs de flamme pourront également être ajoutés ou les composés colorants ou azurants.

Parmi les agents réticulant, on peut citer les isocyanates ou les peroxydes organiques. Cette réticulation permet d'améliorer la stabilité thermique du liant, en particulier sa tenue au fluage, ainsi que l'adhérence avec le support. Ces propriétés sont particulièrement importantes lorsque le liant intervient dans la formation de verre feuilleté ou de panneaux solaires.

Même si la composition peut ne pas comprendre d'agents de couplage, les titanates ou les silanes organiques sont des exemples d'agent de couplage qui peuvent être ajoutés afin d'améliorer l'adhérence lorsque celle-ci doit être particulièrement élevée. Parmi ceux-ci, on peut citer les monoalkyl titanates, ou les trichlorosilanes et les trialkoxysilanes.

Le rayonnement UV entraînant un jaunissement du film, des stabilisants UV peuvent être ajoutés afin d'assurer la transparence du film durant sa durée de vie. Les composés peuvent être par exemple à base de benzophénone ou de benzotriazole.

Des charges, en particulier minérales, peuvent être ajoutées pour améliorer la tenue thermomécanique de la composition. De façon non limitative, on donnera comme exemples la silice, l'alumine, le talc ou les carbonates de calcium ou les nanotubes de carbone. Avantageusement, on utilise des argiles modifiées ou non modifiées qui sont mélangées à l'ordre nanométrique ; ceci permet d'obtenir une composition plus transparente.

Des plastifiants peuvent être ajoutés afin de faciliter la mise en oeuvre et améliorer la productivité du procédé de fabrication de la composition et des structures. On peut citer comme exemples les huiles minérales paraffiniques aromatiques ou naphtaléniques. On peut également citer comme plastifiant les phtalates, azelates, adipates, le phosphate de ticrésyle.

Des agents retardateurs de flamme peuvent également être ajoutés.

On peut également ajouter des composés colorants ou azurants.

Le MFI du liant (ASTM D 1238 - 190°C - 2,16 kg) peut être compris entre 0,1 et 1000 g/10 min. Avantageusement, ce liant a un MFI compris entre 1 et 400 g/10 min : l'adhérence est encore améliorée, tout en pouvant obtenir un film du liant de l'invention par les techniques classiques d'extrusion laminage, extrusion soufflage, etc... Sous cette forme de film, la fabrication de structures multicouches est permise par un simple assemblage des couches avant pressage.

Pour traiter la surface du « back sheet », on peut utiliser un matériau telle une couche de primaire afin d'améliorer l'adhérence au liant. Parmi les primaires, on peut citer les polyuréthanes thermoplastiques, les polyesters, les organosilanes ou encore les silicones. Les liants ont aussi une très bonne adhérence sur ces primaires. Le back sheet peut également être traité par un traitement plasma comme par exemple un traitement corona.

A titre d'exemples de front sheet, on peut citer les plaques de verre ou des plaques ou des films de polymère transparent comme par exemple le PMMA, le polyamide ou les polymères fluorés.

On peut utiliser tout type de cellules photovoltaïques pour fabriquer des modules photovoltaïques. On peut par exemples utiliser les cellules dites « classiques » à base de silicium dopé, monocristallin ou polycristallin ; les capteurs en couche mince formés par exemple de silicium amorphe, de tellurure de cadnium, de disiléniure de cuivre-indium ou de matériaux organiques peuvent également être utilisés pour capter l'énergie solaire.

Les modules photovoltaïques comprenant les liants peuvent être fabriqués par les techniques connues. Par exemple, on peut utiliser la composition sous forme de film. Ce film peut être utilisé comme encapsulant des cellules photovoltaïques. Pour fabriquer un module, on peut assembler successivement, sur une première couche de front sheet, une première couche d'encapsulant, les cellules photovoltaïques, une seconde couche d'encapsulant puis une couche de back sheet.

Le module photovoltaïque peut être formé par exemple par pressage à chaud, sous vide, par laminage et en particulier thermolaminage. Le pressage sous vide est particulièrement préféré. Ce liant est très bien adapté au thermolaminage car il peut être appliqué à basse température (inférieure à 160°C, voire à 150°C).

Un procédé de fabrication de ce module comprend une étape de réticulation de la couche d'encapsulant après assemblage des différentes couches.

De manière préférée, les liants ont une adhérence sur le verre d'au moins 10N/15mm au test de pelage à 90° selon la norme ISO8510-1.

De manière préférée, les liants ont une adhérence sur le PMMA d'au moins 10N/15mm au test de pelage à 90° selon la norme ISO8510-1.

Les couches du multicouche peuvent être formées par exemple par pressage à chaud, sous vide, par laminage et en particulier thermolaminage. Le pressage sous vide est particulièrement préféré. Ce liant est très bien adapté au thermolaminage car il peut être appliqué à basse température (inférieure à 160°C, voire à 150°C).

### EXEMPLES

Pour formuler les exemples de l'invention et comparatifs, les produits suivants ont été utilisés :
EVATANE^{®} 28-150 : C'est un copolymère éthylène-acétate de vinyle fabriqué par ARKEMA dont le taux d'acétate de vinyle est de 28% en masse d'acétate de vinyle et dont le MFI (ASTM D 1238 - 190°C - 2,16 kg) est de 150 g/10min.
EVATANE^{®} 33-45: Copolymère éthylène-acétate de vinyle fabriqué par ARKEMA dont le taux d'acétate de vinyle est de 33% en masse d'acétate de vinyle et dont le MFI (ASTM D 1238 - 190°C - 2,16 kg) est de 45 g/10min.
OREVAC^{®} Terpolymer 9305 : Copolymère éthylène-acétate de vinyle-anhydride maléique fabriqué par ARKEMA dont le taux d'acétate de vinyle est de 28 % en masse et le taux d'anhydride maléique est de 0,8 % en masse, le MFI (ASTM D 1238 - 190°C - 2,16 kg) étant de 180 g/10min.
LOTADER^{®} 7500 : Copolymère éthylène-acrylate d'éthyle -anhydride maléique fabriqué par ARKEMA dont le taux d'acrylate d'éthyle est de 17 % en masse et le taux d'anhydride maléique est de 2,8 % en masse, le MFI (ASTM D 1238 - 190°C-2,16 kg) étant de 70 g/10min.
LOTADER^{®} 4700 : Copolymère éthylène-acrylate d'éthyle -anhydride maléique fabriqué par ARKEMA dont le taux d'acrylate d'éthyle est de 29 % en masse et le taux d'anhydride maléique est de 1,3 % en masse, le MFI (ASTM D 1238 - 190°C - 2,16 kg) étant de 7 g/10min.
LOTADER^{®} AX 8950 : Copolymère éthylène- acrylate de méthyle - méthacrylate de glycidyle fabriqué par ARKEMA dont le taux d'acrylate de méthyle est de 19 % en masse et le taux de méthacrylate de glycidyle est de 9 % en masse, le MFI (ASTM D 1238 - 190°C - 2,16 kg) étant de 85 g/10min. LUPEROX^{®} TBEC : Composition de peroxyde organique comprenant du peroxycarbonate de OO-tertbutyle et de O-(2-éthylhexyle). Agent de couplage : Silane
LACQTENE^{®} 1020 FN 24: PE basse densité fabriqué par Total Petrochemicals dont le MFI est de 2,1g/10min (ASTM D 1238 - 190°C - 2,16 kg).
ALTUGLAS^{®} V825HID: Plaques de PMMA fabriquées par Altuglas de 3,2 mm d'épaisseur dont le point Vicat est de 111 °C (ASTM D 1525, mode A, 1 kg) et le module de flexion est de 3200 MPa à température ambiante (ASTM D 790). Verre : Plaques de 3 mm.
   Back sheet : Film PVDF/PET/PVDF.

### Formulations sans agent réticulant

### Structures PE basse densité/Liant/Verre ou PMMA

On a mesuré ici les niveaux d'adhésion entre le liant de la structure multicouche selon l'invention et comparatif et une couche de verre ou de PMMA.

Dans le Tableau 1 sont reportées les liants de la structure multicouche selon l'invention (EX4, EX5) et comparatifs (CP1, CP2) avec les ratios massiques de chaque composé.

Les exemples EX1, EX2, EX3 sont des exemples de références.

**Tableau 1**

| | CP1 | CP2 | EX1 | EX2 | EX3 | EX4 | EX5 |
|---|---|---|---|---|---|---|---|
| EVATANE^{®} 28-150 | 1 | 0 | 0 | 0 | 0 | 0,7 | 0 |
| EVATANE^{®} 33-45 | 0 | 1 | 0 | 0 | 0 | 0 | 0,7 |
| OREVAC^{®} Terpolymer 9305 | 0 | 0 | 1 | 0 | 0 | 0,3 | 0,3 |
| LOTADER^{®} 7500 | 0 | 0 | 0 | 1 | 0 | 0 | 0 |
| LOTADER^{®} 4700 | 0 | 0 | 0 | 0 | 1 | 0 | 0 |

Les composés des exemples EX3 et EX4 sont prémélangés en sac avant extrusion.

Pour mesurer l'adhésion, des films multicouches PE/liant ont été co-extrudés par la technologie cast-film. Le PEBD a été extrudé à 50 tours par minute dans une extrudeuse monovis COLLIN (diamètre de vis = 45 mm / avec un ratio longueur/diamètre = 25), les températures des 6 zones chauffantes étant 200°C/230°C/240°C/250°C/250°C/250°C. Le liant a été coextrudé à 20 tours par minute dans une extrudeuse mono-vis COLLIN (diamètre de vis = 30 mm / avec un ratio longueur/diamètre = 25), et les températures dépendent de la fluidité intrinsèque du liant à coextruder. Les températures des 6 zones chauffantes sont ainsi réglées à 80°C/100°C/100°C/110°C/110°C/110°C pour les exemples CP1, CP2 et EX5, tandis qu'elles sont réglées à 60°C/70°C/80°C/80°C/80°C/80°C pour les exemples EX1 à EX4. Les deux extrudeuses alimentent un Feedblock (boite de coextrusion) équipé d'une filière plate de largeur 250mm et d'entrefer final 500µm. La température dans ces dispositifs est fixée à 230°C. Le film bicouche ainsi produit est étiré à partir de la sortie de filière dans l'air jusqu'à un rouleau de refroidissement (chill roll) régulé à 20°C à une vitesse de 4,9m/min, ce qui permet la formation du film multicouche, les couches de PE et de liant ayant des épaisseurs respectives de 200 et 20µm.

Le film PE/liant obtenu est pressé à 1 10°C sous une pression de 3 bars pendant 15 minutes contre le support en PMMA ou en verre, la face liant étant en contact direct avec le support. L'éprouvette obtenue est refroidie à température ambiante, et sa résistance au pelage est mesurée immédiatement après fabrication. Celle-ci est évaluée par un test de pelage à 90° selon la norme ISO8510-1.

Les résistances au pelage des exemples et comparatifs mesurées à partir de ce test sont reportées Tableau 2.

La transparence des films obtenus (par le niveau de trouble ou Haze) et leur résistivité ont également été mesurées. Les formulations CP 2, EX1 et EX5 ont été extrudées dans la même extrudeuse COLLIN que celle utilisée pour extruder le liant avec 6 zones chauffantes réglées à 80°C/100°C/100°C/110°C/110°C/ 110°C. Des films de 100µm d'épaisseur ont été préparés par pressage à 120°C des formulations obtenues. Les résultats sont également reportés dans le Tableau 2.

La mesure du Haze des différents films a été réalisée au moyen du spectrophotocolorimètre CM-3610d et du logiciel SpectraMagic NX pour l'analyse des résultats. Pour tous les films étudiés, la mesure du Haze a été réalisée en mode transmission et suivant la norme ASTM D1003-97.

La résistivité électrique transversale a été déterminée à 23°C à l'aide d'un spectromètre diélectrique de type Novocontrol Concept 40. On a reporté la résistivité des échantillons à basse fréquence (0,01 Hz), lorsque cette résistivité est indépendante de la fréquence.

**Tableau 2**

| | Support | CP1 | CP2 | EX1 | EX2 | EX3 | EX4 | EX5 |
|---|---|---|---|---|---|---|---|---|
| Résistance au pelage (N/15mm) | Verre | 3,3 | 0 | 27,3 | 24,5 | 16,5 | 20,2 | 14 |
| | PMMA | 0,5 | 0,6 | 18,2 | 11,7 | Non mesuré | 18 | 17,4 |
| Haze | | Non mesuré | 16,3 | 3.1 | Non mesuré | Non mesuré | Non mesuré | 15 |
| Résistivité électrique (ohm.cm) | | Non mesuré | 3.10¹³ | 2.10¹⁵ | Non mesuré | Non mesure | Non mesuré | 2.10¹⁵ |

Lors des tests, il a été observé qu'il n'y a aucune rupture d'adhérence entre le PE et le liant : ainsi, on ne mesure uniquement la résistance au pelage entre le support et le liant.

Les liants EVA (CP1 et CP2) montrent des résistances au pelage très faibles aux supports verre et PMMA. Les liants de la structure multicouche selon l'invention présentent une résistance au pelage bien supérieure à celle des liants classiques à base d'EVA.

La formulation de l'EX1 montre l'excellente adhérence du terpolymère d'alpha-oléfine, d'ester vinylique d'acide carboxylique et d'anhydride maléique à des supports comme le verre ou le PMMA.

De manière surprenante, les formulations EX4 et EX5 présentent des résistances au pelage proches de celles observées pour la polyoléfine comportant un monomère fonctionnel EX1, bien que le ratio massique d'EVA soit de 0,7. De plus, quelle que soit la fluidité du liant, l'adhérence au PMMA des liants de EX4 et EX5 est même similaire au liant constitué uniquement de la polyoléfine comportant un monomère fonctionnel (EX1).

Par ailleurs, le Haze montre que les formulations comprenant une polyoléfine (B) (EX1 et EX5) sont plus transparentes que la formulation classique à base d'EVA (CP2). De manière surprenante, le mélange de la polyoléfine (B) avec l'EVA (EX5) est même plus transparent que la polyoléfine (B) seule (EX1).

Les résistivités des formulations (EX1 et EX5) sont plus élevées que celle de la formulation comparative à base d'EVA (CP2).

Tous ces résultats montrent bien l'intérêt de l'utilisation des liants de la structure mutlicouche selon l'invention dans les modules photovoltaïques, en particulier comme encapsulant.

## Revendications

1. Structure multicouche comprenant une couche formée de liant et au moins un support constitué de PMMA, ledit liant étant en contact direct avec le support et comprenant un mélange d'un copolymère éthylène-ester vinylique d'acide carboxylique (A) et d'une polyoléfine (B) qui contient un monomère fonctionnel (X) qui est l'anhydride maléique, le ratio massique (B)/((A)+(B)) étant compris dans la gamme allant de 0,05 à inférieur à 1.

2. Structure selon la revendication 1 dans laquelle le ratio massique (B)/((A)+(B)) est compris entre 0,05 et 0,5.

3. Structure selon l'une des revendications précédentes dans laquelle la polyoléfine (B) comprend de l'éthylène.

4. Structure selon l'une des revendications précédentes dans laquelle le monomère fonctionnel (X) contenu dans la chaîne de la polyoléfine (B) est copolymérisé.

5. Structure selon l'une des revendications précédentes dans laquelle la quantité du monomère fonctionnel (X) dans la polyoléfine (B) est comprise entre 0,05 et 10 % en masse.

6. Structure selon l'une des revendications précédentes dans laquelle la polyoléfine (B) contenant un monomère fonctionnel (X) est un copolymère éthylène/(meth)acrylate d'alkyle/anhydride maléique.

7. Structure selon l'une des revendications 1 à 5 dans laquelle la polyoléfine (B) contenant un monomère fonctionnel (X) est un copolymère éthylène/acétate de vinyle/anhydride maléique.

8. Structure selon l'une des revendications précédentes dans laquelle le copolymère (A) est un copolymère éthylène/acétate de vinyle.

9. Structure selon l'une des revendications précédentes dans laquelle le taux d'ester vinylique d'acide carboxylique du copolymère (A) est compris entre 25 et 45 % en masse.

10. Structure selon l'une des revendications précédentes dans laquelle le liant a un MFI compris entre 1 et 400 g/10min (190°C, 2,16 kg).

## Patentansprüche

1. Mehrschichtstruktur mit einer Schicht aus Bindemittel und mindestens einem Träger aus PMMA, wobei das Bindemittel in direktem Kontakt mit dem Träger steht, umfassend eine Mischung aus einem Ethylen-Carbonsäurevinylester-Copolymer (A) und einem Polyolefin (B), das ein funktionelles Monomer (X) enthält, dessen funktionellen Monomer (X) um Maleinsäureanhydrid handelt, wobei das Massenverhältnis (B)/( (A)+(B)) im Bereich von 0,05 bis weniger als 1 liegt.

2. Mehrschichtstruktur nach Anspruch 1 wobei das Massenverhältnis (B) I ((A) + (B)) zwischen 0,05 und 0,5 liegt.

3. Mehrschichtstruktur nach einem der vorhergehenden Ansprüche, wobei das Polyolefin (B) Ethylen umfasst.

4. Mehrschichtstruktur nach einem der vorhergehenden Ansprüche, wobei das in der Kette des Polyolefins (B) enthaltende funktionelle Monomer (X) copolymerisiert ist.

5. Mehrschichtstruktur nach einem der vorhergehenden Ansprüche, wobei die Menge des funktionellen Monomers (X) in dem Polyolefin (B) zwischen 0,05 und 10 Gew.- % liegt. 6.

6. Mehrschichtstruktur nach einem der vorhergehenden Ansprüche, wobei es sich bei dem ein funktionelles Monomer (X) enthaltenden Polyolefin (B) um ein Ethylen/Aikyl(meth)acrylat/Maleinsaureanhydrid-Copolymer handelt.

7. Mehrschichtstruktur nach einem der Ansprüche 1 bis 5, wobei es sich bei dem ein funktionelles Monomer (X) enthaltenden Polyolefin (B) um ein EthylenNinylacetat/Maleinsaureanhydrid-Copolymer handelt.

8. Mehrschichtstruktur nach einem der vorhergehenden Ansprüche, wobei es sich bei dem Copolymer (A) um ein Ethylen/Vinylacetat-Copolymer handelt.

9. Mehrschichtstruktur nach einem der vorhergehenden Ansprüche, wobei der Carbonsaurevinylestergehalt des Copolymers (A) zwischen 25 und 45 Gew.-% liegt.

10. Mehrschichtstruktur nach einem der vorhergehenden Ansprüche, wobei das Bindemittel einen MFI zwischen 1 und 400 g/10 min (190°C, 2,16 kg) aufweist.

## Claims

1. Multilayer structure comprising a layer formed from a tie and at least one support made of PMMA, said tie being in direct contact with the support and comprising a blend of an ethylene/carboxylic acid vinyl ester copolymer (A) and a polyolefin (B) which contains a functional monomer (X) which is maleic anhydride, the B/(A+B) weight ratio being within the range of 0.05 to inferior to 1.

2. Structure according to Claim 1, in which the B/(A+B) weight ratio is between 0.05 and 0.5.

3. Structure according to either of the preceding claims, in which the polyolefin (B) comprise ethylene.

4. Structure according to one of the preceding claims, in which the functional monomer (X) contained in the chain of the polyolefin (B) is copolymerized.

5. Structure according to one of the preceding claims, in which the amount of the functional monomer (X) in the polyolefin (B) is between 0.05 and 10 wt%.

6. Structure according to one of the preceding claims, in which the polyolefin (B) containing a functional monomer (X) is an ethylene/alkyl (meth)acrylate/maleic anhydride copolymer.

7. Structure according to one of Claims 1 to 5, in which the polyolefin (B) containing a functional monomer (X) is an ethylene/vinyl acetate/maleic anhydride copolymer.

8. Structure according to one of the preceding claims, in which the copolymer (A) is an ethylene/vinyl acetate copolymer.

9. Structure according to one of the preceding claims, in which the carboxylic acid vinyl ester content of the copolymer (A) is between 25 and 45 wt%.

10. Structure according to one of the preceding claims, in which the tie has an MFI between 1 and 400 g/10 min (190°C, 2.16 kg).
